# EUROPÄISCHE PATENTSCHRIFT

(11) **EP 3 807 660 B1**
(45) Veröffentlichungstag und Bekanntmachung des Hinweises auf die Patenterteilung: **10.08.2022**
(21) Anmeldenummer: 19731691.2
(22) Anmeldetag: 14.06.2019
(51) Int. Cl.: G01R 31/28

(54) **VERFAHREN UND VORRICHTUNG ZUM ELEKTRISCHEN PRÜFEN EINER ELEKTRISCHEN BAUGRUPPE**
METHOD AND DEVICE FOR ELECTRICAL TESTING OF AN ELECTRICAL ASSEMBLY
PROCÉDÉ ET DISPOSITIF DE VÉRIFICATION ÉLECTRIQUE D'UN MODULE ÉLECTRIQUE

(30) Priorität: 18.06.2018 DE 102018209738; 11.10.2018 DE 102018217406
(43) Veröffentlichungstag der Anmeldung: 21.04.2021
(73) Patentinhaber: Ateip GmbH, 01109 Dresden (DE)
(72) Erfinder: POHL, Ulrich, Baybay City Lethe, 6521 (PH)
(74) Vertreter: Pfenning, Meinig & Partner mbB
(86) Internationale Anmeldenummer: PCT/EP2019/065682
(87) Internationale Veröffentlichungsnummer: WO 2019/243188

(56) Entgegenhaltungen:
- EP-A1- 0 171 322
- WO-A1-00/42442
- WO-A1-84/02412
- US-A1- 2008 084 225

## Beschreibung

Die vorliegende Erfindung betrifft ein Verfahren und eine Vorrichtung zum elektrischen Prüfen einer elektrischen Baugruppe bzw. eines elektrischen Bauelements.

Beim Herstellen bzw. Bestücken elektrischer Baugruppen, insbesondere Leiterplatten (die auch als Platine, gedruckte Schaltung oder "printed circuit boards" (PCB), bezeichnet werden), integrierten Schaltungen oder elektrischen bzw. elektronischen Bauelementen können vielfältige Fehler auftreten, wie zum Beispiel fehlerhafte Bauteile bzw. Komponenten, Bauteile, die vergessen wurden aufzubringen oder an der falschen Stelle aufgebracht wurden sowie nicht funktionierende oder nicht hinreichend funktionierende elektrische Verbindungen. Während und nach dem Herstellen von elektrischen Baugruppen werden unter anderem elektrische Testsysteme verwendet, um derartige Defekte zu detektieren und die Qualität des Produktionsprozesses sowie beispielsweise die Qualität der hergestellten Leiterplatten zu überwachen.

Ein typisches elektrisches Testsystem bzw. ein typischer elektrischer Tester weist in der Regel eine "bed-of-nail"-Anordnung, die die zu prüfende Einheit hält, sowie eine automatisierte Messeinheit zum Durchführen der Messungen auf. Federbelastete Messfühler, die "nails", werden hierbei zum Kontaktieren der elektrischen Schaltung auf der Leiterplatte verwendet, wobei die Einheit, die überprüft werden soll, mehr als tausend derartiger kontaktierter Messpunkte bzw. Testpunkte aufweisen kann, die alle mit der Messeinheit elektrisch verbunden sind.

Die Messeinheit umfasst hierbei typischerweise bisher eine Schaltmatrix und Messgeräte, die in der Lage sind, mehrere Parameter wie elektrische Spannung, elektrischen Strom, elektrischen Widerstand, Kapazität und Induktivität zu messen und gegenüber Vorgaben zu bewerten. Bei diesem Verfahren wird somit, bedingt durch eine Architektur des bisherigen Testsystems eine sequenzielle Messung aller Bauteile bzw. Komponenten, bei der nacheinander für jedes dieser Bauteile erst eine elektrische Verbindung über die Schaltmatrix hergestellt wird, die elektrischen Parameter gemessen und verglichen werden und die elektrische Verbindung wieder getrennt wird, angewandt. Dieses Verfahren ist prinzipbedingt sehr zeitaufwändig und aufgrund der Vielzahl von durchzuführenden Schritten und der unzuverlässigen Relaismatrix auch fehlerbehaftet.

Die Druckschrift US 2008/0084225 A1 offenbart beispielsweise eine Messeinheit zum Testen von Leiterplatten, bei der seitlich angebrachte Kontaktierungen verwendet werden. Aus WO 84/02412 A1 ist eine Vorrichtung bekannt, mit der eine Vielzahl unterschiedlicher Schaltkreise geprüft werden können. Das Dokument WO 00/42442 A1 befasst sich mit einem Verfahren und einer Vorrichtung zum Testen von Leiterplatten, bei dem Widerstandswerte bei Anlegen eines elektrischen Stroms gemessen werden. Aus EP 0 171 322 A1 ist ferner ein Verfahren bekannt, bei dem ein Eingangssignal an einen Schaltkreis angelegt wird und nachfolgend mehrere Messungen der jeweiligen Antwort des Schaltkreises durchgeführt werden.

Der vorliegenden Erfindung liegt daher die Aufgabe zugrunde, ein Verfahren und eine Vorrichtung vorzuschlagen, mit denen die genannten Nachteile vermieden werden können, also schnell und zuverlässig eine elektrische Baugruppe überprüft werden kann.

Diese Aufgabe wird erfindungsgemäß gelöst durch ein Verfahren nach Anspruch 1 und eine Vorrichtung nach Anspruch 6. Vorteilhafte Ausgestaltungen und Weiterbildungen sind in den abhängigen Ansprüchen beschrieben.

Bei einem Verfahren zum elektrischen Prüfen einer elektrischen Baugruppe auf Defekte bzw. auch zum Prüfen von einer mit elektrischen oder elektronischen Komponenten der elektrischen Baugruppe bestückten Leiterplatte oder eines entsprechend bestückten anderen Trägers auf Defekte werden gleichzeitig alle elektrischen oder elektronischen Bauteile vermessen, indem durch eine Steuer-/Auswerteeinheit ein elektrisches Abbild der elektrischen Baugruppe aufgenommen wird. Zum Aufnehmen dieses elektrischen Abbilds wird gleichzeitig an mehreren, also mindestens zwei Testpunkten der Leiterplatte, die beliebig angeordnet sein können, oder an allen Messpunkten jeweils ein elektrisches Anregungssignal aus einem elektrischen Strom oder einer elektrischen Spannung durch die Steuer-/Auswerteeinheit und mehrere Treiberschaltungen angelegt. Die über die Treiberschaltungen angelegten elektrischen Anregungssignale unterscheiden sich hinsichtlich ihrer spektralen Charakteristik voneinander, bei mehr als zwei verwendeten elektrischen Anregungssignale unterscheiden diese sich paarweise bezüglich ihrer spektralen Charakteristik voneinander. Der in den jeweiligen Testpunkt fließende elektrische Strom und die resultierende elektrische Spannung in Bezug auf ein elektrisches Massepotential werden hinsichtlich einer Wellenform synchron aufgezeichnet und nachfolgend Parameter der Bauteile und ihrer elektrischen Verbindungen durch die Steuer-/Auswerteeinheit berechnet.

Durch die gleichzeitige Messung kann das Verfahren mit gesteigerter Effizienz durchgeführt werden, da nun nicht mehr eine Vielzahl sequenziell ausgeführter Messungen, sondern nur noch eine parallele Messung der Baugruppe, also insbesondere einer Leiterplatte, eines integrierten Schaltkreises bzw. eine Bauelements, verwendet wird. Indem die elektrischen Anregungssignale sich in ihrer spektralen Charakteristik unterscheiden, kann eine eindeutige Bestimmung des jeweiligen Messpunkts aus dem detektierten Signal erfolgen, es wird quasi aus zeitlich parallel gewonnen Informationen auf den jeweiligen Testpunkt und ein diesem Testpunkt beispielsweise zugeordnetes Bauteil zurückgerechnet. Da die Testpunkte ein elektrisches Netz kontaktieren, kann eine Vielzahl von Informationen erlangt werden, die aufgrund der wohldefinierten, also insbesondere voneinander unterscheidbaren angelegten Anregungssignale, beispielsweise durch eine passende Filterung aufgeschlüsselt werden können. Wellenformen sowohl der in den jeweiligen Testpunkten fließenden elektrischen Ströme als auch Wellenformen der resultierenden elektrischen Spannungen in Bezug auf ein elektrisches Massepotential werden typischerweise synchron aufgezeichnet, wobei das elektrische Abbild der zu prüfenden elektrischen Baugruppe durch die Gesamtheit dieser synchron aufgezeichneten Wellenformen gebildet wird. Jedes der Anregungssignale soll hierbei eine von allen anderen eindeutig unterscheidbare spektrale Charakteristik, also eine von allen anderen Anregungssignalen unterscheidbare Wellenform aufweisen. Durch auf diese Anregungssignale abgestimmte Filter, die beispielsweise als Algorithmus in der Steuer-/Auswerteeinheit realisiert sind, lassen sich für jede im elektrischen Abbild aufgezeichnete Wellenform eines der Anregungssignale sowohl das bzw. die diese Wellenform verursachende Anregungssignal bzw. Anregungssignale als auch die Art der Beeinflussung des Anregungssignals auf die gemessene Wellenform identifizieren. Daraus können die Parameter der Bauelemente, die von den Orten der verschiedenen Anregungen zum Ort der aufgezeichneten Wellenform, also bis zum Testpunkt, angeordnet sind, berechnet und mit vorgegebenen Werten vergleichen. Hierdurch können sowohl fehlende als auch fehlerhafte elektrische Verbindungen auf der zu prüfenden Baugruppe als auch Abweichungen der Parameter von Sollwerten erkannt werden.

Es kann vorgesehen sein, dass sich die elektrischen Anregungssignale in ihrer Signalform unterscheiden, d. h. dass die spektrale Charakteristik die Signalform als Unterscheidungsmerkmal aufweist. Alternativ oder zusätzlich kann aber auch eine Signallänge als Unterscheidungsmerkmal der spektralen Charakterisik dienen, um zuverlässige Rückschlüsse zu ermöglichen. Vorzugsweise wird jedoch eine Amplitude der elektrischen Anregungssignale für jedes dieser Signale gleich groß gewählt, um eine gleichmäßige Beaufschlagung aller Testpunkte zu gewährleisten.

Typischerweise werden die berechneten und bzw. oder gemessenen Parameter (d. h. insbesondere das elektrische Abbild) in einer Speichereinheit gespeichert. Die Speichereinheit kann hierbei direkt an die Steuer-/Auswerteeinheit angeschlossen sein und in einer Vorrichtung integriert sein, die beide Einheiten umfasst, es kann aber auch vorgesehen sein, die Daten von der Steuer-/Auswerteeinheit an eine räumlich getrennte Speichereinheit zu übermitteln, die in einer weiteren Vorrichtung untergebracht ist. Die Speichereinheit selbst kann in der Regel sowohl die Messwerte als auch die Parameter speichern, wobei die Parameter typische Werte der Bauelemente sind, also beispielsweise ein elektrischer Widerstand des jeweiligen Bauelements. Ebenso kann auch eine direkte Verarbeitung der Daten durch die Steuer-/Auswerteeinheit in Echtzeit, also insbesondere ohne Zwischenspeicherung, erfolgen. Die Steuer-/Auswerteeinheit und die Speichereinheit können auch über eine Datenübermittlungseinheit und eine Datenempfangseinheit, also beispielsweise über eine Funkverbindung, miteinander verbunden sein und sich in unterschiedlichen Geräten befinden, also räumlich getrennt voneinander sein.

Die berechneten bzw. in der Speichereinheit gespeicherten Parameter können durch die Steuer-/Auswerteeinheit auch mit vorgegebenen Werten verglichen werden, um sofort Abweichungen festzustellen.

Die Steuer-/Auswerteeinheit ist in der Regel ein kombiniertes Gerät, das sowohl zum Steuern als auch zum Auswerten eingerichtet ist, kann aber in weiteren Ausführungsbeispielen auch in Form von zwei Einheiten, einer Steuereinheit und einer Auswerteeinheit vorgesehen sein, die dann nur Steuern und nur Auswerten.

Eine Vorrichtung zum elektrischen Prüfen einer elektrischen Baugruppe ist mit einer Steuer-/Auswerteeinheit versehen, die eingerichtet ist, gleichzeitig an mehreren oder auch an allen Testpunkten der elektrischen Baugruppe über mehrere Treiberschaltungen jeweils ein elektrisches Anregungssignal aus einem elektrischen Strom oder einer elektrischen Spannung anzulegen. Die über die Treiberschaltungen angelegten elektrischen Anregungssignale unterscheiden sich hinsichtlich ihrer spektralen Charakteristik voneinander. Die Steuer-/Auswerteeinheit ist weiter dazu eingerichtet, gleichzeitig alle auf dem Träger aufgebrachten elektrischen oder elektronischen Bauteile durch Aufnehmen eines elektrischen Abbilds der Leiterplatte zu messen und für jeden Testpunkt den in diesen Testpunkt fließenden elektrischen Strom und die resultierende elektrische Spannung hinsichtlich einer Wellenform in Bezug auf ein elektrisches Massepotential synchron aufzuzeichnen sowie Parameter der Bauteile und ihrer elektrischen Verbindungen zu berechnen.

Es kann vorgesehen sein, dass die Treiberschaltungen bis auf ihre elektrische Verbindung zu der Steuer-/Auswerteeinheit voneinander elektrisch isoliert sind, um Störsignale zu minimieren. Jedem der Testpunkte bzw. Messpunkte ist hierbei typischerweise genau eine einzelne Treiberschaltung zugeordnet. Jede der Treiberschaltungen kann zwei, typischerweise genau zwei, elektrische Signalverbindungen zum Kontaktieren eines einzelnen der Testpunkte aufweisen. Eine erste der zwei elektrischen Signalverbindungen ist hierbei mit einem Ausgang der jeweiligen Treiberschaltung verbunden und dient dem Beaufschlagen des jeweiligen Messpunkts bzw. Testpunkts mit dem elektrischen Anregungssignal, eine zweite der zwei elektrischen Signalverbindungen ist mit einem Eingang der jeweiligen Treiberschaltung verbunden und dient dem Aufnehmen und Weiterleiten der resultierenden Spannung im Testpunkt. Somit kann eine zuverlässige Kontaktierung für jeden der Testpunkte erreicht werden. Die beiden Verbindungen können getrennt, beispielsweise über je eine eigene Nadel bzw. ein eigenes Kontaktierlement, zum jeweiligen Messpunkt bzw. Testpunkt geführt sein, wodurch störende Einflüsse der Kontaktierung verringert werden. Die beiden Verbindungen können aber auch, gegebenenfalls auch nur teilweise, über eine gemeinsam genutzte Leitung oder eine gemeinsam genutzte Nadel oder ein anderes Kontaktierelement den jeweiligen Testpunkt kontaktieren.

Die Bezugspotentiale aller Treiberschaltungen sind typischerweise identisch bzw. alle miteinander elektrisch verbunden. Zumindest eine der Treiberschaltungen kann aber auch ein von den restlichen Treiberschaltungen abweichendes elektrisches Bezugspotential aufweisen.

Die gesamte Vorrichtung (oder auch einzelne Teile davon), insbesondere aber die Steuer-/Auswerteeinheit und die Treiberschaltungen können in mindestens einer anwendungsspezifischen integrierten Schaltung (ASIC) kombiniert angeordnet sein, um einen kompakten Aufbau zu ermöglichen. Es kann auch vorgesehen sein, die Steuer-/Auswerteeinheit und die Treiberschaltungen in mehreren anwendungsspezifischen Schaltungen anzuordnen. Vorzugsweise ist die genannte Vorrichtung in die zu prüfende Baugruppe integriert, um einen möglichst kompakten Aufbau und eine Prüfung der Funktionsfähigkeit auch bei verbauter Baugruppe durchführen zu können. Dadurch wird zwar die zu prüfende Baugruppe in ihrem Aufbau aufwändiger, die Kontaktierung und der eigentliche Prüfvorgang werden jedoch erleichtert. Zudem kann in diesem Fall zu jedem Zeitpunkt, der wünschenswert oder notwendig erscheint, die Baugruppe geprüft werden, ohne hierzu ein separates Testgerät zu benutzen. Es liegt somit ein System aus der beschriebenen Vorrichtung und der zu prüfenden Baugruppe vor. Es kann auch vorgesehen sein lediglich einzelne Teile der Vorrichtung, insbesondere die Treiberschaltungen, in die zu prüfende Baugruppe zu integrieren.

Mit der Ausgabeeinheit kann in der Vorrichtung eine Ausgabeeinheit elektrisch verbunden sein, die dazu eingerichtet ist, bei einem detektierten Defekt ein Fehlersignal auszugeben. Somit kann ein Benutzer einfach und schnell auf einen vorliegenden Defekt aufmerksam gemacht werden. In besonders bevorzugter Weise wird das als defekt detektierte Bauteil auf der Ausgabeeinheit ausgegeben, um eine effiziente Fehlerkontrolle zu ermöglichen. Das Fehlersignal kann sowohl optisch als auch akustisch ausgestaltet sein.

Die beschriebene Vorrichtung kann zumindest teilweise, aber auch gänzlich in der zu prüfenden elektrischen Schaltung integriert sein.

Ein Computerprogrammprodukt weist ein Computerprogramm (bzw. eine Befehlsfolge) auf, das Softwaremittel zum Durchführen des beschriebenen Verfahrens und bzw. oder zum Ansteuern der beschriebenen Vorrichtung aufweist, wenn das Computerprogramm in einem Automatisierungssystem oder in einer Recheneinheit abläuft. Vorzugsweise kann das Computerprogrammprodukt direkt in einen internen Speicher bzw. eine Speichereinheit der Recheneinheit geladen werden oder ist in diesem bereits gespeichert und umfasst typischerweise Teile eines Programmcodes zum Durchführen des beschriebenen Verfahrens oder zum Ansteuern der beschriebenen Vorrichtung, wenn das Computerprogrammprodukt auf der Recheneinheit abläuft bzw. ausgeführt wird. Das Computerprogrammprodukt kann auf einem maschinenlesbaren Träger, vorzugsweise einem digitalen Speichermedium gespeichert sein.

Das beschriebene Verfahren ist typischerweise mit der beschriebenen Vorrichtung durchführbar, d. h. die beschriebene Vorrichtung ist zum Durchführen des beschriebenen Verfahrens ausgebildet.

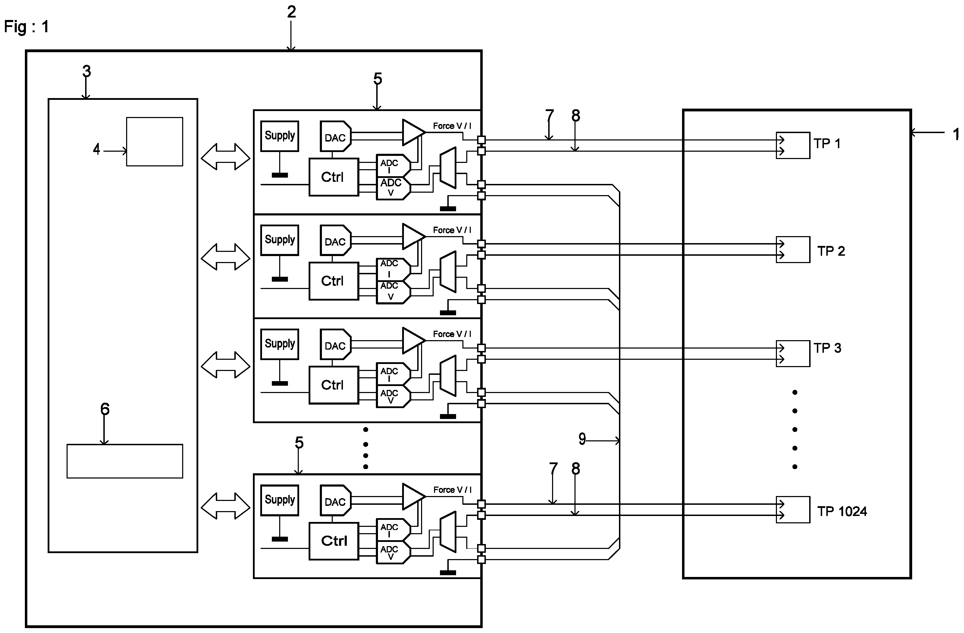

Ein Ausführungsbeispiel der Erfindung ist in der Zeichnung dargestellt und wird nachfolgend anhand von Figur 1 erläutert.

Figur 1 zeigt in einer schematischen Ansicht eine Leiterplatte 1 als eine zu prüfende Baugruppe, die mit in der schematischen Übersicht nicht dargestellten elektrischen und elektronischen Bauteilen bestückt ist bzw. aus diesen besteht. Die gesamte Leiterplatte 1 samt der darauf angeordneten Bauteile und diese verbindenden elektrischen Leitungen sollen mit einer Messvorrichtung 2 überprüft werden. Anstelle der Leiterplatte 1 kann auch eine beliebige andere Baugruppe oder ein Bauelement verwendet werden, auf dem die elektrischen und bzw. oder elektronischen Bauteile einer gemeinsam mit dem Träger zu prüfenden elektrischen Schaltung angeordnet sind. Insbesondere kann ein einzelner Mikrochip die elektrische Schaltung beinhalten.

Die Messvorrichtung 2 weist eine Steuer-/Auswerteeinheit 3 auf, in der eine Speichereinheit 4 und eine Ausgabeeinheit 6, im dargestellten Ausführungsbeispiel ein Display, angeordnet sind. Die Steuer-/Auswerteeinheit 3 steuert mehrere Treiberschaltungen 5 in einer im Folgenden beschriebenen Weise an. In dem in Figur dargestellten Ausführungsbeispiel sind insgesamt 1024 Treiberschaltungen 5 vorhanden, die mit ebenso vielen Testpunkten TP auf der Leiterplatte 1 elektrisch verbunden sind.

Jedem der auf der Leiterplatte 1 angeordneten Testpunkte TP wird genau eine Treiberschaltung 5 der Messvorrichtung 2 zugeordnet. Jeder der Testpunkte TP, die beliebige Punkte oder Netze der elektrischen Schaltung auf der Leiterplatte 1 markieren, wird über zwei Signalverbindungen 7, 8 bzw. Signalleitungen mit der Messvorrichtung 2 verbunden. Jede Signalverbindung 7 ist mit einem einzelnen Ausgang einer der Treiberschaltungen 5 verbunden, während jede Signalverbindung 8 mit einem Eingang einer der Treiberschaltungen 5 elektrisch verbunden ist. Jeweils eine der Signalverbindungen 7 und eine der Signalverbindungen 8 bilden ein Signalverbindungspaar bzw. Signalleitungspaar, das einer der Treiberschaltungen 5 zugeordnet ist. Die Signalverbindung 7 kann auch als Stimulusleitung bezeichnet werden, die Signalverbindung 8 als Akquisitionsleitung. Außerdem sind alle Treiberschaltungen 5 in einer Sternschaltung an ein gemeinsames Massepotential mit entsprechenden Masseverbindungen 9 bzw. Masseleitungen verbunden.

Angesteuert von der Steuer-/Auswerteeinheit 3 wird durch jede der Treiberschaltungen 5 jeder Testpunkt TP gleichzeitig mit einem Anregungssignal über die Signalverbindung 7 beaufschlagt. Das Anregungssignal umfasst einen elektrischen Strom oder eine elektrische Spannung, wobei sich die von den Treiberschaltungen 5 bereitgestellten Anregungssignale paarweise in ihrer spektralen Charakteristik unterscheiden.

Über die Signalverbindung 8 wird nachfolgend, aber in einem ebenfalls für alle Signalverbindungen 8 und Testpunkte TP gleichzeitig erfolgenden Messvorgang die in dem jeweiligen Testpunkt TP resultierende elektrische Spannung gemessen und über die Treiberschaltung 5 an die Steuer-/Auswerteeinheit 3 übermittelt. Die Treiberschaltungen 5 sind in ihrem Aufbau im Wesentlichen identisch und untereinander elektrisch isoliert. Außerdem sind auch die Signalverbindungen 7 und 8 zueinander elektrisch isoliert.

Durch die gleichzeitig aufgenommenen Messwerte, die von jedem der Testpunkte TP an die Steuer-/Auswerteeinheit 3 übermittelt werden, ergibt sich ein elektrisches Abbild der Leiterplatte 1 aus Wellenformen der elektrischen Spannung und des elektrischen Stroms an jedem Testpunkt. Diese Wellenformen werden durch die Anregungssignale verursacht. Da jeweils jedes Anregungssignal für sich eine von allen anderen eindeutig unterscheidbare Signalform und gleichzeitig eine von allen anderen eindeutig unterscheidbare spektrale Charakteristik aufweist, kann durch auf die Anregungssignale abgestimmte Filter, die als Algorithmus in der Steuer-/Auswerteeinheit enthalten sind, für jede an den Testpunkten aufgezeichnete Wellenform berechnet werden, von welchen Testpunkten aus die Wellenform verursacht wurde und welcher Größe und Art die Beeinflussung ist. Damit kann erkannt werden, ob die elektrischen Verbindungen und Bauelemente die geforderten elektrischen Eigenschaften haben oder es durch Fehler verursachte Abweichungen gibt. Da jeder der Testpunkte mit einem durch die jeweilige spektrale Charakteristik eindeutig zuordenbaren Anregungssignal beaufschlagt wurde, kann durch eine Nachbearbeitung der empfangenen Signale, beispielsweise durch eine Filterung und bzw. oder eine Fourier-Transformation, auf den jeweiligen Testpunkt rückgeschlossen werden. Die Anregungssignale unterscheiden sich hierbei in der Regel in ihren Signalformen, also beispielsweise sinusförmig oder rechteckförmig, weisen jedoch typischerweise eine identische Amplitude auf.

Die Steuer-/Auswerteeinheit 3 berechnet schließlich aus allen Messpunkten dieses elektrischen Abbildes Parameter von Komponenten der elektrischen Leiterplatte 1 und speichert diese in der Speichereinheit 4. Die Berechnung kann ganz oder zumindest teilweise gleichzeitig zum Messvorgang erfolgen. Ferner sind in der Speichereinheit 4 bereits Referenzwerte enthalten, die mit den berechneten Parametern jedes Testpunkts TP verglichen werden. Beispielsweise kann hier eine Differenzbildung der Werte erfolgen und bei Überschreiten oder Unterschreiten eines Grenzwerts der Differenz ein Warnsignal ausgegeben werden. Dieses Warnsignal kann auch nur die Information umfassen, ob das durch den Testpunkt getestete Bauteil in Ordnung ist oder nicht. Als Defekt im Sinn des vorliegenden Verfahrens soll hierbei insbesondere ein fehlerhaftes Bauteil, ein Bauteil, das vergessen wurden aufzubringen oder an der falschen Stelle aufgebracht wurde sowie eine nicht funktionierende oder nicht hinreichend funktionierende elektrische Verbindung wie beispielsweise einen Kurzschluss angesehen werden.

Durch das beschriebene Verfahren und die dafür vorgesehenen Vorrichtungen kann insbesondere die ansonsten übliche Schaltmatrix eingespart werden. Neben dem Vorteil einer höheren Messgeschwindigkeit und einer höheren Fehlerabdeckung bzw. Fehlererkennung werden durch die gleichzeitige Messung auch Informationen über eine Wechselwirkung zwischen verschiedenen Messpunkten bzw. Testpunkten erhalten. Da die beschriebene Vorrichtung auch als einzelner Chip bzw. ASIC oder als Kombination von Chips hergestellt werden kann, ist auch ein kompakter Aufbau gegeben. Zudem ist es auch möglich, eine gleichzeitige zeitaufgelöste Messung durch die Treiberschaltungen 5 und die Steuer-/Auswerteeinheit 3 durchzuführen.

Lediglich bzw. sämtliche in den Ausführungsbeispielen offenbarte Merkmale der verschiedenen Ausführungsformen können miteinander kombiniert und einzeln beansprucht werden.

## Patentansprüche

1. Verfahren zum elektrischen Prüfen einer elektrischen Baugruppe auf Defekte, bei dem
gleichzeitig alle auf einem Träger (1) aufgebrachten elektrischen oder elektronischen Bauteile vermessen werden,
indem durch eine Steuer-/Auswerteeinheit (3) ein elektrisches Abbild der elektrischen Baugruppe aufgenommen wird,
bei dem gleichzeitig an mehreren Testpunkte (TP) der elektrischen Baugruppe, die beliebig auf dem Träger angeordnet sein können, jeweils ein elektrisches Anregungssignal aus einem elektrischen Strom oder einer elektrischen Spannung durch die Steuer-/Auswerteeinheit (3) und mehreren Treiberschaltungen (5) angelegt wird,
wobei sich die über die Treiberschaltungen (5) angelegten elektrischen Anregungssignale hinsichtlich ihrer spektralen Charakteristik unterscheiden, und
der in den jeweiligen Testpunkt (TP) fließende elektrische Strom und die resultierende elektrische Spannung hinsichtlich einer Wellenform in Bezug auf ein elektrisches Massepotential synchron aufgezeichnet werden, sowie nachfolgend
Parameter der Bauteile und ihrer elektrischen Verbindungen durch die Steuer-/Auswerteeinheit (3) berechnet werden.

2. Verfahren nach Anspruch 1, **dadurch gekennzeichnet, dass** sich die elektrischen Anregungssignale in ihrer Signalform unterscheiden.

3. Verfahren nach einem der Ansprüche 1 oder 2, **dadurch gekennzeichnet, dass** eine Amplitude der elektrischen Anregungssignale gleich ist.

4. Verfahren nach einem der vorhergehenden Ansprüche, **dadurch gekennzeichnet, dass** die berechneten Parameter in einer Speichereinheit (4) gespeichert werden.

5. Verfahren nach Anspruch 4, **dadurch gekennzeichnet, dass** die gespeicherten Parameter mit vorgegebenen Parametern der Bauteile verglichen werden.

6. Vorrichtung (2) zum elektrischen Prüfen einer elektrischen Baugruppe, bei der
eine Steuer-/Auswerteeinheit (3) eingerichtet ist, gleichzeitig an mehreren Testpunkten (TP) der elektrischen Baugruppe, die beliebig auf einer auf einem Träger der elektrischen Baugruppe angeordnet sein können, über mehrere Treiberschaltungen (5) jeweils ein elektrisches Anregungssignal aus einem elektrischen Strom oder einer elektrischen Spannung anzulegen, wobei
sich die über die Treiberschaltungen (5) angelegten elektrischen Anregungssignale hinsichtlich ihrer spektralen Charakteristik unterscheiden, und gleichzeitig alle auf dem Träger (1) aufgebrachten elektrischen oder elektronischen Bauteile durch Aufnehmen eines elektrischen Abbildes der Leiterplatte zu messen und
die Steuer-/Auswerteeinheit (3) weiter eingerichtet ist, für jeden Testpunkt (TP) den in diesen Testpunkt (TP) fließenden elektrischen Strom und die resultierende elektrische Spannung hinsichtlich einer Wellenform in Bezug auf ein elektrisches Massepotential synchron aufzuzeichnen sowie Parameter der Bauteile und ihrer elektrischen Verbindungen zu berechnen.

7. Vorrichtung (2) nach Anspruch 6, **dadurch gekennzeichnet, dass** die Treiberschaltungen (5) bis auf ihre elektrische Verbindung zu der Steuer-/Auswerteeinheit (3) voneinander elektrisch isoliert sind.

8. Vorrichtung (2) nach Anspruch 6 oder Anspruch 7, **dadurch gekennzeichnet, dass** jede der Treiberschaltungen (5) zwei elektrische Signalverbindungen (7, 8) zum Kontaktieren eines einzelnen der Testpunkte (TP) aufweist, wobei eine der zwei elektrischen Signalverbindungen (7, 8) mit einem Ausgang der jeweiligen Treiberschaltung (5) verbunden ist und die zweite der zwei elektrischen Signalverbindungen (7, 8) mit einem Eingang der jeweiligen Treiberschaltung (5) verbunden ist.

9. Vorrichtung (2) nach einem der Ansprüche 6 bis 8, **dadurch gekennzeichnet, dass** die Steuer-/Auswerteeinheit (3) und die Treiberschaltungen (5) in einer anwendungsspezifischen integrierten Schaltung, ASIC, oder mehreren anwendungsspezifischen integrierten Schaltungen kombiniert angeordnet sind.

10. Vorrichtung nach einem der Ansprüche 7 bis 9, **dadurch gekennzeichnet, dass** eine Ausgabeeinheit (6) mit der Steuer-/Auswerteeinheit (3) elektrisch verbunden und eingerichtet ist, bei einem detektierten Defekt ein Fehlersignal auszugeben sowie vorzugsweise das defekte Bauteil anzugeben.

11. Elektrische Schaltung, zumindest teilweise oder gänzlich umfassend eine Vorrichtung nach einem der Ansprüche 6 bis 10.

12. Computerprogrammprodukt aufweisend ein Computerprogramm, das Softwaremittel aufweist, die bewirken, dass die Vorrichtung nach einem der Ansprüche 6 bis 10 angesteuert wird, das Verfahren nach einem der Ansprüche 1 bis 5 durchzuführen, wenn das Computerprogramm in einer Recheneinheit abläuft.

## Claims

1. A method for electrical testing of an electrical assembly for defects, in which
all electrical or electronic parts mounted on a support (1) are measured simultaneously,
in that an electrical image of the electrical assembly is received by a control/evaluation unit (3),
in which an electrical excitation signal of an electrical current or an electrical voltage is applied simultaneously by the control/evaluation unit (3) and a plurality of driver circuits (5) at a plurality of test points (TP) of the electrical assembly, which test points may be arranged in any way on the support,
wherein the electrical excitation signals applied via the driver circuits (5) differ with regard to their spectral characteristic, and
the electrical current flowing in the particular test point (TP) and the resultant electrical voltage are recorded synchronously with regard to a waveform in relation to an electrical ground potential, and subsequently
parameters of the parts and their electrical connections are calculated by the control/evaluation unit (3).

2. The method according to claim 1, **characterized in that** the electrical excitation signals differ in their signal form.

3. The method according to one of claims 1 or 2, **characterized in that** an amplitude of the electrical excitation signals is the same.

4. The method according to one of the preceding claims, **characterized in that** the calculated parameters are stored in a memory unit (4).

5. The method according to claim 4, **characterized in that** the stored parameters are compared with predefined parameters of the parts.

6. A device (2) for electrically testing an electrical assembly, in which
a control/evaluation unit (3) is designed to apply an electrical excitation signal of an electrical current or an electrical voltage simultaneously via a plurality of driver circuits (5) at a plurality of test points (TP) of the electrical assembly, which test points may be arranged in any way on a support of the electrical assembly, wherein
the electrical excitation signals applied via the driver circuits (5) differ with regard to their spectral characteristic and all electrical or electronic parts mounted on the support (1) are to be measured simultaneously by recording an electrical image of the printed circuit board, and
the control/evaluation unit (3) is also designed to record synchronously, for each test point (TP), the electrical current flowing in said test point (TP) and the resultant electrical voltage with regard to a waveform in relation to an electrical ground potential and to calculate parameters of the parts and their electrical connections.

7. The device (2) according to claim 6, **characterized in that** the driver circuits (5) are electrically insulated from one another apart from their electrical connection to the control/evaluation unit (3).

8. The device (2) according to claim 6 or claim 7, **characterized in that** each of the driver circuits (5) has two electrical signal connections (7, 8) for contacting an individual one of the test points (TP), wherein one of the two electrical signal connections (7, 8) is connected to an output of the particular driver circuit (5) and the second of the two electrical signal connections (7, 8) is connected to an input of the particular driver circuit (5).

9. The device (2) according to one of claims 6 to 8, **characterized in that** the control/evaluation unit (3) and the driver circuits (5) are arranged combined in an application-specific integrated circuit, ASIC, or a plurality of application-specific integrated circuits.

10. The device according to one of claims 7 to 9, **characterized in that** an output unit (6) is electrically connected to the control/evaluation unit (3) and is designed to output an error signal in the event that a defect is detected and preferably to specify the defective part.

11. An electrical circuit, at least partially or wholly comprising a device according to one of claims 6 to 10.

12. A computer program product comprising a computer program which comprises software means which cause that the device according to one of claims 6 to 10 is actuated, the method according to one of claims 1 to 5 is carried out, when the computer program is run in a computing unit.

## Revendications

1. Procédé pour tester électriquement les défauts d'un ensemble électrique, dans lequel
tous les composants électriques ou électroniques montés sur un support (1) sont mesurés simultanément,
en capturant une image électrique du ensemble électrique au moyen d'une unité de commande/d'évaluation (3),
dans lequel un signal d'excitation électrique constitué d'un courant électrique ou d'une tension électrique est appliqué simultanément à plusieurs points de test (TP) du ensemble électrique, qui peuvent être disposés de manière quelconque sur le support, par l'unité de commande/d'évaluation (3) et plusieurs circuits d'attaque (5),
les signaux électriques d'excitation appliqués par l'intermédiaire des circuits d'attaque (5) se distinguant par leurs caractéristiques spectrales, et
le courant électrique circulant dans le point de test respectif (TP) et la tension électrique résultante sont enregistrés de manière synchrone en ce qui concerne une forme d'onde par rapport à un potentiel de masse électrique, et ensuite
les paramètres des composants et de leurs connexions électriques sont calculés par l'unité de commande/d'évaluation (3).

2. Procédé selon la revendication 1, **caractérisé en ce que** les signaux électriques d'excitation se distinguent par leur forme de signal.

3. Procédé selon l'une des revendications 1 ou 2, **caractérisé en ce qu'**une amplitude des signaux électriques d'excitation est égale.

4. Procédé selon l'une des revendications précédentes, **caractérisé en ce que** les paramètres calculés sont mémorisés dans une unité de mémorisation (4).

5. Procédé selon la revendication 4, **caractérisé en ce que** les paramètres mémorisés sont comparés à des paramètres prédéfinis des composants.

6. Dispositif (2) pour tester électriquement un ensemble électrique, dans lequel
une unité de commande/d'évaluation (3) est conçue pour appliquer simultanément à plusieurs points de test (TP) du ensemble électrique, qui peuvent être disposés de manière quelconque sur un support du ensemble électrique, respectivement un signal d'excitation électrique à partir d'un courant électrique ou d'une tension électrique par l'intermédiaire de plusieurs circuits d'attaque (5), dans lequel
les signaux électriques d'excitation appliqués par l'intermédiaire des circuits d'attaque (5) se distinguent par leurs caractéristiques spectrales, et pour mesurer simultanément tous les composants électriques ou électroniques montés sur le support (1) en capturant une image électrique du circuit imprimé, et
l'unité de commande/d'évaluation (3) est en outre conçue pour enregistrer de manière synchrone, pour chaque point de test (TP), le courant électrique circulant dans ce point de test (TP) et la tension électrique résultante en ce qui concerne une forme d'onde par rapport à un potentiel de masse électrique, ainsi que pour calculer des paramètres des composants et de leurs connexions électriques.

7. Dispositif (2) selon la revendication 6, **caractérisé en ce que** les circuits d'attaque (5) sont isolés électriquement les uns des autres à l'exception de leur connexion électrique à l'unité de commande/d'évaluation (3).

8. Dispositif (2) selon la revendication 6 ou la revendication 7, **caractérisé en ce que** chacun des circuits d'attaque (5) comprend deux connexions de signaux électriques (7, 8) pour contacter un seul des points de test (TP), l'une des deux connexions de signaux électriques (7, 8) étant connectée à une sortie du circuit d'attaque respectif (5) et la deuxième des deux connexions de signaux électriques (7, 8) étant connectée à une entrée du circuit d'attaque respectif (5).

9. Dispositif (2) selon l'une des revendications 6 à 8, **caractérisé en ce que** l'unité de commande/d'évaluation (3) et les circuits d'attaque (5) sont disposés dans un circuit intégré spécifique à l'application, ASIC, ou dans plusieurs circuits intégrés spécifiques à l'application combinés.

10. Dispositif selon l'une des revendications 7 à 9, **caractérisé en ce qu'**une unité de sortie (6) est connectée électriquement à l'unité de commande/d'évaluation (3) et est conçue pour émettre un signal d'erreur en cas de défaut détecté et, de préférence, pour indiquer le composant défectueux.

11. Circuit électrique comprenant au moins partiellement ou entièrement un dispositif selon l'une des revendications 6 à 10.

12. Produit programme d'ordinateur comprenant un programme d'ordinateur qui comprend des moyens logiciels pour commander le dispositif selon l'une quelconque des revendications 6 à 10 afin d'exécuter le procédé selon l'une quelconque des revendications 1 à 5 lorsque le programme d'ordinateur est exécuté dans une unité de calcul.
